# EUROPEAN PATENT APPLICATION

(11) **EP 4 306 676 A1**
(43) Date of publication of application: **17.01.2024**
(21) Application number: 22767184.9
(22) Date of filing: 09.03.2022
(51) Int. Cl.: C23C 16/40, C23C 16/455, H01L 21/365, H01L 21/368

(54) **SEMICONDUCTOR DEVICE**

(30) Priority: 12.03.2021 JP 2021039807
(71) Applicant: SHIN-ETSU CHEMICAL CO., LTD., Tokyo 1000005 (JP)
(72) Inventor: SAKATSUME, Takahiro, Annaka-shi, Gunma 379-0195 (JP)
(74) Representative: Sonnenhauser, Thomas Martin
(86) International application number: PCT/JP2022/010240
(87) International publication number: WO 2022/191230

(57) **Abstract**

The present invention is a film-forming method for heat-treating a raw material solution atomized into a mist and performing a film-formation, and the method includes the following steps: atomizing the raw material solution or making the raw material solution into droplets to generate a mist; conveying the mist to a film-forming part by a carrier gas; and supplying the mist from a nozzle to a substrate, heat-treating the mist on the substrate, and performing the film-formation in the film-forming part, wherein with the area of an opening surface of the nozzle being S [cm²], the longest distance among distances between points in the opening surface and the surface of the substrate being H [cm], and the flow rate of the carrier gas supplied from the nozzle being Q [L/min], SH/Q≥0.015 results. Thus, the present invention provides: the film-forming method for suppressing abnormal growth and forming a film having good surface smoothness.

## Description

### TECHNICAL FIELD

The present invention relates to a film-forming method for performing a film-formation on a substrate using a mist-like raw material solution.

### BACKGROUND ART

A high-vacuum film-formation apparatus that can achieve non-equilibrium state, such as pulsed laser deposition (PLD), molecular beam epitaxy (MBE), and sputtering, have been developed, enabling to fabricate an oxide semiconductor that was previously impossible to fabricate using a conventional method such as a melt method. Mist chemical vapor deposition (hereinafter referred to as a mist CVD method) using the atomized mist-like raw material solution to grow crystal on a substrate, has also been developed, enabling to fabricate a gallium oxide (α-Ga₂O₃) having a corundum structure. As a semiconductor with a large band gap, α-Ga₂O₃ is expected to be applied to next-generation switching device that can achieve high-voltage, low loss, and high heat resistance.

With reference to the mist CVD method, Patent Document 1 describes a tubular furnace type mist CVD apparatus. Patent Document 2 describes a fine channel type mist CVD apparatus. Patent Document 3 describes a linear source type mist CVD apparatus. Patent Document 4 describes a mist CVD apparatus of a tubular furnace, which differs from the mist CVD apparatus described in Patent Document 1 in that a carrier gas is introduced into a mist generator. Patent Document 5 describes a mist CVD apparatus in which a substrate is placed above a mist generator and a susceptor is a rotating stage mounted on a hot plate.

### CITATION LIST

### PATENT LITERATURE

Patent Document 1: JP H01-257337 A
Patent Document 2: JP 2005-307238 A
Patent Document 3: JP 2012-046772 A
Patent Document 4: JP 5397794 B1
Patent Document 5: JP 2014-063973 A

### SUMMARY OF INVENTION

### TECHNICAL PROBLEM

Unlike the other CVD methods, the mist CVD method can perform a film-formation at relatively low temperatures, and it is also possible to fabricate a crystal structure of a metastable phase such as the corundum structure of α-Ga₂O₃. However, the present inventors found that when the film-formation is performed using the mist CVD method, pits are formed on a film surface, resulting in the film surface having poor surface smoothness. There is also a problem that a film including many pits causes the pits to be killer defect, resulting in dielectric breakdown of a semiconductor apparatus. In addition, removal of the pits by polishing is problematic due to increasing the number of processes in creating the semiconductor apparatus.

The present invention has been made to solve the above-described problems. An object of the present invention to provide: a film having suppressed pits and good surface smoothness; and a film-forming method for performing a film-formation such a film.

### SOLUTION TO PROBLEM

The present invention has been made to achieve the above object. The present invention provides an oxide semiconductor film including gallium as main component, the oxide semiconductor film having a corundum structure, wherein pits on the surface of the oxide semiconductor film are 10000 pits/cm² or less.

Such oxide semiconductor film is simply and inexpensively obtained, and moreover has excellent surface smoothness, allowing to use suitable for a semiconductor apparatus.

In this case, the pits on the surface of the oxide semiconductor film can be 100 pits/cm² or less.

This further improves the surface smoothness and enables to use more suitable for the semiconductor apparatus.

In this case, the oxide semiconductor film can have an area of 10 cm² or more.

This results in a large-area oxide semiconductor film having excellent surface smoothness that can be suitably used in the semiconductor apparatus.

In this case, the pits on the surface of the oxide semiconductor film have an opening diameter of 10 nm to 10 µm and the pits have a depth of 10 nm to 10 pm.

This results in a large-area oxide semiconductor film having further excellent surface smoothness that can be even more suitably used in the semiconductor apparatus.

In this case, the semiconductor apparatus can include the above oxide semiconductor film.

This results in the semiconductor apparatus having excellent characteristics.

The present invention also provides a film-forming method for heat-treating a raw material solution atomized into a mist and performing a film-formation, the method includes the following steps:
atomizing the raw material solution or making the raw material solution into droplets to generate mist;
conveying the mist to a film-forming part by a carrier gas; and
supplying the mist from a nozzle to a substrate, heat-treating the mist on the substrate, and performing the film-formation in the film-forming part,
wherein with the area of an opening surface of the nozzle being S [cm²], the longest distance among distances between points in the opening surface and the surface of the substrate being H [cm], and the flow rate of the carrier gas supplied from the nozzle being Q [L/min], SH/Q≥0.015 results.

According to such film-forming method, the pits on the surface are suppressed, and thus the film having good smoothness can be formed.

In this case, the raw material solution can contain gallium.

This enables to suppress the pits on the surface, and thus the gallium-containing film with good smoothness can be formed.

In this case, the raw material solution can contain halogen.

This enables to suppress the pits on the surface, and thus the film having better smoothness can be formed.

In this case, with the temperature of the heat-treatment being T[°C], ST/Q≥40 can result.

This enables further to suppress the pits on the surface, and thus the film having even better smoothness can be formed.

In this case, the mist can be supplied to the substrate from the nozzle provided vertically above the substrate.

This enables further to suppress the pits on the surface, and thus the film having even better smoothness can be formed.

In this case, the substrate can be moved under the nozzle.

This enables to form the film having fewer pits on the surface and good smoothness on a large-area.

In this case, with the area of the surface of the substrate to be performed the film-formation being A [cm²], S/A≤0.3 can result.

This enables to form the film having fewer pits on the surface and good smoothness on a large-area.

In this case, the opening surface of the nozzle can be rectangular.

This enables to form the film having fewer pits on the surface and good smoothness on a large-area.

In this case, with the length of the long axis of the opening surface of the nozzle being L [cm] and the maximum length in the long axis direction of the nozzle within the surface of the substrate to be performed the film-formation being R [cm], L/R≥1 can result.

This enables to simply form the film having fewer pits on the surface and good smoothness on a large-area.

In this case, the area of the substrate can be 10 cm² or more.

This enables to form the film having fewer pits on the surface and good smoothness on a large-area.

### ADVANTAGEOUS EFFECTS OF INVENTION

As described above, the oxide semiconductor film according to the present invention can reduce the pits, have the excellent smoothness on the surface, and can be used suitable for the semiconductor apparatus.

In addition, the film-forming method according to the present invention allows to form the film having fewer pits on the surface and good smoothness by way of simple method in the mist CVD method.

### BRIEF DESCRIPTION OF DRAWINGS

FIG. 1 is a schematic block view illustrating an example of a film-forming apparatus used in the present invention.
FIG. 2 is a view describing an example of an atomizing part used in the present invention.
FIG. 3 is a view describing an example of a film-forming part used in the present invention.
FIG. 4 is a view describing an example of a nozzle used in the present invention.
FIG. 5 is a view describing an example of the film-forming part provided with a plurality of nozzles.
FIG. 6 is a view describing an example of the nozzle provided with a plurality of opening surfaces.
FIG. 7 is a view describing an example of the nozzle used in the present invention.
FIG. 8 is a view describing an example of the nozzle used in the present invention.
FIG. 9 is a view describing an example of a movement mechanism of the substrate used in the present invention.
FIG. 10 is a view describing an example of the moving mechanism reciprocating under the nozzle.
FIG. 11 is a view describing an example of a rotary moving mechanism moving under the nozzle in one direction.
FIG. 12 is a view illustrating the results of a test example 1.
FIG. 13 is a view describing a structure of the semiconductor apparatus created in a test example 2.
FIG. 14 is a view illustrating the results of a test example 2.
FIG. 15 is a view illustrating a pit.
FIG. 16 is a view describing an example of an oxide semiconductor film according to the present invention.

### DESCRIPTION OF EMBODIMENTS

As described above, there was a need to provide an oxide semiconductor film having fewer pits and excellent surface smoothness inexpensively, and to provide a method for producing an oxide semiconductor film having fewer pits and excellent surface smoothness which is formed in a manner with simple, inexpensive, and low-temperature process.

The present inventors have earnestly studied the above problem and consequently found that, an oxide semiconductor film including gallium as main component, the oxide semiconductor film having a corundum structure, wherein pits on the surface of the oxide semiconductor film are 10000 pits/cm² or less, can be simply and inexpensively obtained, has the excellent surface smoothness, and can be used suitably for a semiconductor apparatus. This finding has led to the completion of the present invention.

The present inventors have earnestly studied the above problem and consequently found that, a film-forming method for heat-treating a raw material solution atomized into a mist and performing a film-formation, the method including the following steps: atomizing the raw material solution or making the raw material solution into droplets to generate a mist; conveying the mist to a film-forming part by a carrier gas; and supplying the mist from a nozzle to a substrate, heat-treating the mist on the substrate, and performing the film-formation in the film-forming part, wherein with the area of an opening surface of the nozzle being S [cm²], the longest distance among distances between points in the opening surface and the surface of the substrate being H [cm], and the flow rate of the carrier gas supplied from the nozzle being Q [L/min], SH/Q≥0.015 results, enables to form a film with fewer pits and good smoothness. This finding has led to the completion of the present invention.

Hereinafter, the present invention will be described in detail. However, the present invention is not limited thereto.

Hereinafter, the present invention will be described with reference to the drawings.

### Oxide Semiconductor Film

An oxide semiconductor film according to the present invention includes gallium as main component, and has a corundum structure, wherein pits on the surface of the oxide semiconductor film are 10000 pits/cm² or less. While an oxide semiconductor film is typically composed of metal and oxygen, in the oxide semiconductor film according to the present invention, the metal contains gallium as main component. Herein, termed a main component means that 50 to 100% of the metal component is gallium. Termed a "gallium-based" means that the metal contains gallium as a metal component. Examples of metal components other than gallium may include one or more metals selected from iron, indium, aluminum, vanadium, titanium, chromium, rhodium, iridium, nickel, and cobalt.

The pits are preferably less than 10000 pits/cm², more preferably 100 pits/cm² or less, and even more preferably less than 100 pits/cm². Although a lower limit of the pits is not particularly limited, it may be 0.01 pits/cm² or more.

Dopants can be included in the oxide semiconductor film depending on the application. Examples of dopants include, but not particularly limited to, n- type dopants such as tin, germanium, silicon, titanium, zirconium, vanadium, or niobium, or p-type dopants such as copper, silver, tin, iridium, or rhodium. The concentration of dopants may be, for example, about 1.0×10¹⁶ to 1.0×10²²/cm³, and may be as low as about 1.0×10¹⁷/cm³ or less, or as high as about 1.0×10²⁰/cm³ or more.

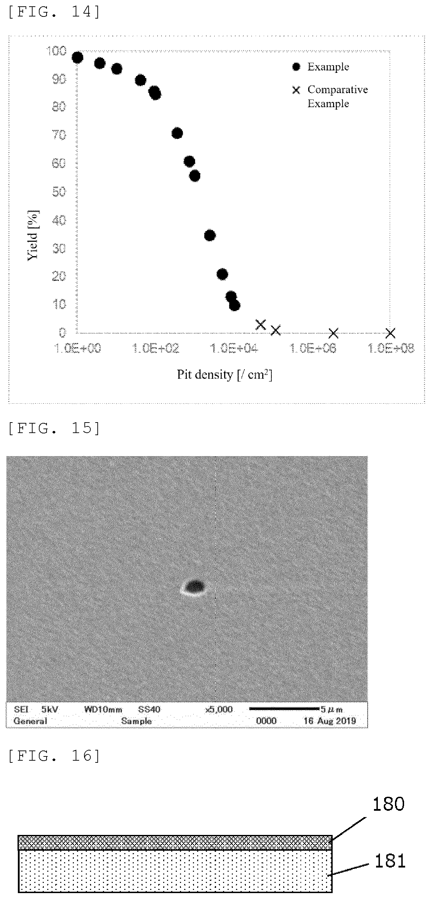

Herein, termed a pit in the present invention represents a recess formed on the film surface as shown in FIG. 15, and can be observed by an optical microscope, SEM, TEM, etc. The opening diameter of the pit is about 10 nm to 10 µm, and the depth of the pit is 10 nm to 10 pm.

Although the details of the reason for occurring pits are unknown, it is presumed that, when the velocity component of the mist in the direction orthogonal to the substrate is large and the weight (moisture content) of the mist at the point of arrival at the substrate is high, the impulse results in large when the mist collides the substrate, and causes an excessive amount of raw material component to be locally supplied and unreacted components or side-reactants in the mist to remain in the film. It is presumed that, the presence of such residues on the film surface leads the film to be less likely to grow locally. Therefore, it is presumed that, the conditions described hereafter can reduce the velocity component of the mist in the direction orthogonal to the substrate and the weight (moisture content) of the mist at the point of arrival at the substrate to reduce, thereby suppressing a pit-formation.

In the oxide semiconductor film according to the present invention, the film thickness is not particularly limited. For example, it may be 0.05 to 100 µm, preferably 0.1 to 50 µm, and more preferably 0.5 to 20 pm.

The oxide semiconductor film 180 according to the present invention is formed on the substrate 181 as shown in FIG. 16.

The other layer may be interposed between the substrate 181 and the oxide semiconductor film 180. The other layer refers to a layer that differs in composition from the substrate 181 and the topmost oxide semiconductor film 180. It can be, for example, a crystalline oxide film, an insulating film, or a metal film.

The oxide semiconductor film preferably has an area of 10 cm² or more, and if circular, a diameter of 2 inches (50 mm) or more is preferable. Although the upper limit of the area is not particularly limited, it is preferably 750 cm² or less, and if circular, the diameter of 12 inches (300 mm) or less is preferable.

The oxide semiconductor film according to the present invention can be used in a semiconductor apparatus by performing an appropriate structural design. The oxide semiconductor film can comprise the respective semiconductor layers for the semiconductor apparatus such as Schottky barrier diode (SBD), metal semiconductor field effect transistor (MESFET), high electron mobility transistor (HEMT), metal oxide film semiconductor field effect transistor (MOSFET), electrostatic induction transistor (SIT), junction field effect transistor (JFET), insulated gate type bipolar transistor (IGBT), light-emitting diode (LED).

### Film-Forming Apparatus

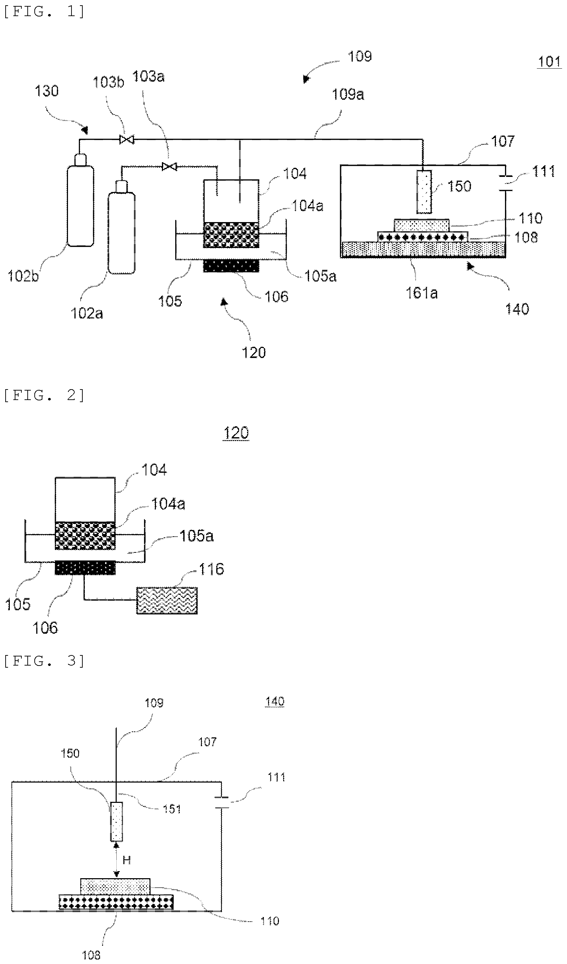

FIG. 1 shows an example of a film-forming apparatus 101 that can be used for the film-forming method according to the present invention. The film-forming apparatus 101 has an atomizing part 120 atomizing a raw material solution into a mist to generate a mist, a carrier gas supplier 130 supplying a carrier gas to convey the mist, a film-forming part 140 heat-treating the mist and performing the film-formation on a substrate, and a conveying part 109 connecting the atomizing part 120 with the film-forming part 140 as well as conveying the mist by means of the carrier gas. The film-forming apparatus 101 may be also controlled by a control unit (not shown) controlling the entire or a part of the film-forming apparatus 101.

Herein, termed a mist in the present invention refers to a generic term for fine liquid particles dispersed in a gas, including those called mists, droplets, etc.

### (Atomizing Part)

In the atomizing part 120, the raw material solution is atomized into a mist to generate a mist. An atomizing method is not particularly limited and may be any atomizing methods that the raw material solution can be atomized into a mist. Although any known atomizing methods can be used, it is preferable to use an atomizing method using ultrasonic wave vibration, as it can atomize the raw material solution into a mist more stably.

An example of such atomizing part 120 is shown in FIG. 2. For example, it may include a mist generating source 104 in which the raw material solution 104a is contained, a container 105 in which a medium capable of transmitting ultrasonic wave vibration, for example water 105a is contained, and an ultrasonic wave vibration 106 attached to the bottom of the container 105. Particularly, the mist generating source 104 consisting of a container in which the raw material solution 104a is contained, is stored in the container 105 in which the water 105a is contained, using a support (not shown). The ultrasonic wave vibration 106 is provided on the bottom of the container 105, and is connected to an oscillator 116. It is configured that when the oscillator 116 is activated, the ultrasonic wave vibration 106 vibrates, and ultrasonic wave vibration propagates through the water 105a into the mist generating source 104 to atomize the raw material solution 104a into a mist.

### (Carrier Gas Supplier)

The carrier gas supplier 130 may have a carrier gas source 102a supplying the carrier gas, and include a flow control valve 103a to adjust the flow rate of the carrier gas delivered from the carrier gas source 102a. It can also include a carrier gas source for dilution 102b supplying the carrier gas for dilution as needed, or a flow control valve 103b to adjust the flow rate of the carrier gas for dilution delivered from the carrier gas source for dilution 102b. There may be not only one but also two or more places for supplying the carrier gas.

### (Film-Forming Part)

In the film-forming part 140, a mist is heated and heat-treated to perform the film-formation on a part or the entire of the surface of a substrate 110. The film-forming part 140 may or may not be partially or entirely enclosed in the film-forming part 140. For example, as shown in FIG. 1, the entire of the film-forming part 140 may be enclosed to form a film-forming chamber 107. In the film-forming part 140, the substrate 110 can be installed, and a hot plate 108 is provided for heating the substrate 110. The hot plate 108 may be provided inside the film-forming chamber 107 as shown in FIG. 1, or may be provided outside the film-forming chamber 107. It can also be provided with a moving stage 161a. The details are described below.

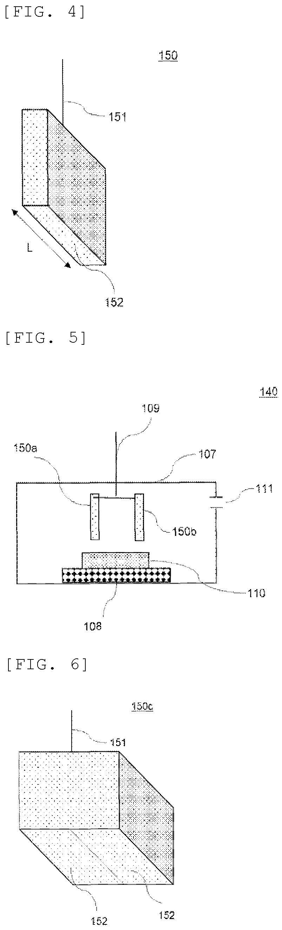

Furthermore, the film-forming part 140 is provided with a nozzle 150 for supplying a mist to the substrate 110, as shown in FIG. 3. An example of the nozzle 150 is shown in FIG. 4. The nozzle 150 has a connection 151 connecting the nozzle 150 to the conveying part 109, and an opening surface 152 of the nozzle for spraying the mist. The position at which the nozzle 150 is provided is not particularly limited. As shown in FIG. 3, the substrate 110 may be installed on the bottom surface of the film-forming chamber 107 and the nozzle 150 may be installed vertically above the substrate to be face up. In contrast, the substrate 110 may be installed on the top surface of the film-forming chamber 107 and the nozzle 150 may be installed vertically below the substrate to be face down.

The number of the nozzle and the opening surface of the nozzle is not particularly limited and may be any number of the nozzles and the opening surfaces of the nozzles if they have one or more. As shown in FIG. 5, a plurality of nozzles 150a and 150b are provided, and as shown in FIG. 6, the nozzles 150c may have a plurality of opening surfaces.

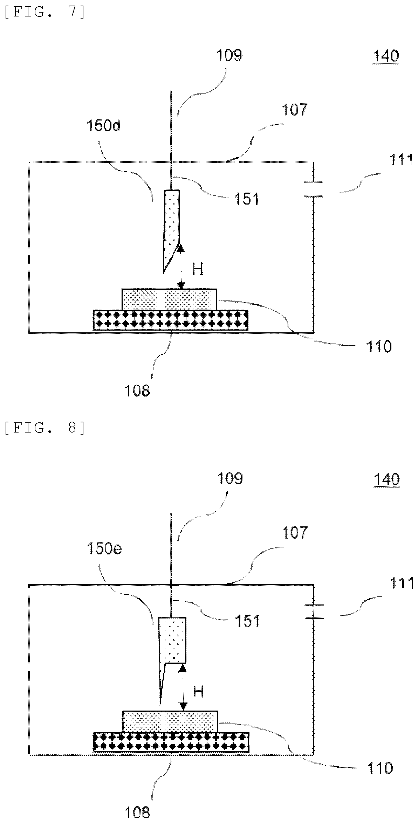

The angle formed by the plane including the opening surface 152 of the nozzle and the plane including the substrate 110 is not particularly limited. As shown in FIG. 7, a nozzle 150d including the opening surface 152 of the nozzle inclined to facilitate the mist flow in a specific direction may be provided. As shown in FIG. 8, a nozzle 150e inclined a part of the opening surface of the nozzle may be provided. However, the substrate 110 and the opening surface of the nozzle are preferably parallel, as shown in FIG. 4, as the film-formation with a simpler structure, fewer pits, and excellent smoothness can be performed.

The film-forming part 140 may be also provided with a position adjustment mechanism (not shown) to allow the longest distance H [cm] among distances between points in the opening surface 152 of the nozzle and the surface of the substrate 110 to be adjusted as appropriate, to the extent described below.

The nozzle 150 may be a structure assembled from a plurally of members such that the area of the opening surface of the nozzle can be adjusted as appropriate by adjusting the size of the members.

The shape of the opening surface 152 of the nozzle is not particularly limited. Although it may be polygonal, circular, elliptical, etc., it is preferably square, and more preferably rectangular.

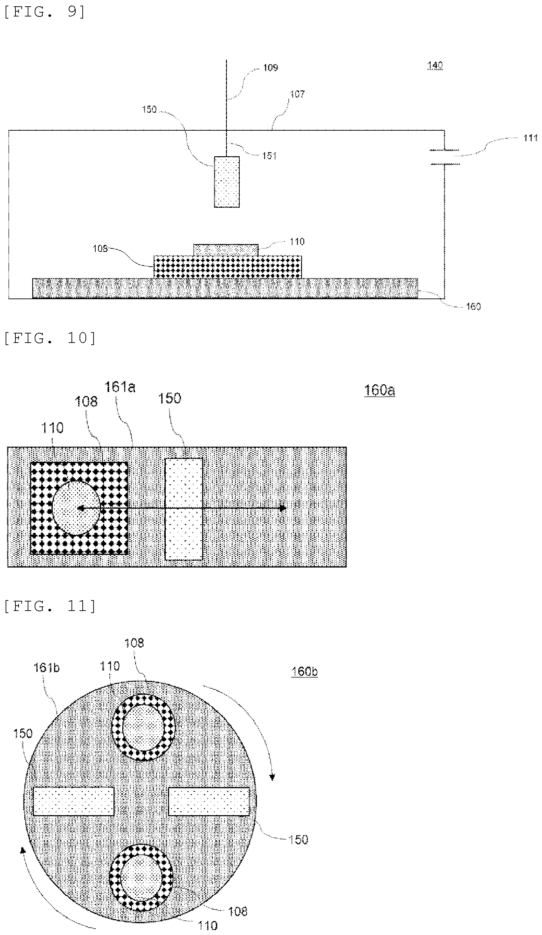

As shown in FIG. 9, the film-forming part 140 can be provided with a moving mechanism 160 moving the substrate 110 below the nozzle 150. The direction in which the substrate is moved is not particularly limited. A view of the film-forming part 140 with the moving mechanism 160a and 160b viewed from vertically above the substrate 110 is shown in FIGs. 10 and 11. There is a method for including the moving stage 161a on which the substrate 110 and the hot plate 108 are placed to move back and forth under the nozzle 150, as shown in FIG. 10, or a method for rotatively moving the substrate 110 and the hot plate 108 under the nozzle 150 by a moving stage 161b on which the substrate 110 and the hot plate 108 are placed, as shown in FIG. 11. In this case, the substrate can also be rotated on its own axis with a mechanism that allows the substrate to rotate on its own axis.

When providing the moving mechanism for the substrate, the speed at which the substrate is moved and the moving range are not particularly limited. However, the number of times per minute that one substrate passes under the nozzle may be 0.1 times or more, preferably 0.5 times or more, and more preferably 1 time or more. The number of times being 0.1 or more leads to be no areas where more gas is locally supplied (i.e., SH/Q does not decrease locally), resulting in the film having no increased pits and good surface smoothness. Although the upper limit of the number of times is not particularly limited, 120 times or less is good, preferably 60 times or less because as the number of times increases, the substrate fixation becomes unstable due to inertial forces.

More specifically, in the case of the moving mechanism as shown in FIG. 10, with the moving speed of the substrate being v [mm/min] relative to the width of moving on the substrate D [mm], v/D may be 0.1/min or more, preferably 0.5/min or more to 120/min or less, and more preferably 1 to 60/min. Although D is not particularly limited, the diameter of the substrate R [mm] or more (100 mm or more for 4 inches, for example) is preferable. Although the upper limit of D is not particularly limited, the larger it is, the more films can be formed on a large number of substrates per nozzle. However, due to decrease of the film-forming speed per substrate, it is preferable to limit the number of substrates to be performed the film-formation per nozzle to 1000 mm or less for high productivity. Although v is not particularly limited, it may be 10 mm/min or more to 30000 mm/min or less, preferably 30 mm/min or more to 12000 mm/min or less, more preferably 60 mm/min or more to 6000 mm/min or less. In the case of the rotatively moving mechanism, as shown in FIG. 11, it may be 0.1 rpm or more, preferably 0.5 to 120 rpm, and more preferably 1 to 60 rpm.

If the film-forming part 140 is enclosed, an exhaust gas outlet 111 may be provided at a location that does not affect the supply of the mist to the substrate 110. The exhaust gas outlet 111 may be provided at one location or at two or more locations if not affecting the mist supply.

### (Conveying Part)

The conveying part 109 connects the atomizing part 120 with the film-forming part 140. The mist is conveyed through the conveying part 109 from the mist generating source 104 of the atomizing part 120 to the nozzle 150 of the film-forming part 140 by means of the carrier gas. The conveying part 109 can be, for example, a supply pipe 109a. For example, a quartz tube or a resin tube can be used as the supply tube 109a.

### Film-Forming Method

Then, a film-forming method according to the present invention will be described. The present invention is a film-forming method for heat-treating a raw material solution atomized into a mist and performing a film-formation, and the method includes the following steps: atomizing the raw material solution or making the raw material solution into droplets to generate a mist; conveying the mist to a film-forming part by a carrier gas; and supplying the mist from a nozzle to a substrate, heat-treating the mist on the substrate, and performing the film-formation in the film-forming part, wherein with the area of an opening surface of the nozzle being S [cm²], the longest distance among distances between points in the opening surface and the surface of the substrate being H [cm], and the flow rate of the carrier gas supplied from the nozzle being Q [L/min], SH/Q≥0.015 results.

### (Step for Generating a Mist)

First, the raw material solution 104a is atomized or the raw material solution 104a is made into droplets to generate a mist. This step can be performed using the atomizing part 120 as described above. Herein, the raw material solution (aqueous solutions) 104a is not particularly limited and may be any raw material solutions (aqueous solutions) 104a containing a material, which may be an inorganic or organic material that can be atomized into a mist. A material solution containing metal or metal compounds is suitable for the raw material solution. The raw material solution containing one or more metal selected from gallium, iron, indium, aluminum, vanadium, titanium, chromium, rhodium, nickel, and cobalt can be used. Among these, the raw material solution containing gallium is particularly preferred, and thus gallium-containing film with suppressed pits and good smoothness can be formed.

Although the raw material solution is not particularly limited and may be any raw material solutions that can atomize the above metal (compound) into a mist, the metal can be dissolved or dispersed in an organic solvent or water in the form of a complex or salt to suitably use as the raw material solution. Examples of complex forms include acetylacetonate complex, carbonyl complex, amine complex, hydride complex, etc. Examples of salt forms include metal chloride salt, metal bromide salt, and metal iodide salt. The above metal can be also dissolved in hydrobromic acid, hydrochloric acid, hydroiodic acid, etc. to use as an aqueous salt solution. A solute concentration is preferably 0.01 to 1 mol/L. Among these, the raw material solution containing halogen is particularly preferred as it suppresses the pits more and enables the film-formation with better smoothness.

In addition, the raw material solution may be mixed with additives such as hydrohalic acid or oxidant. Examples of hydrohalic acid include hydrobromic acid, hydrochloric acid, and hydroiodic acid. Among these, hydrobromic acid or hydroiodic acid is preferred. Examples of oxidants include peroxide such as hydrogen peroxide (H₂O₂), sodium peroxide (Na₂O₂), barium peroxide (BaO₂), benzoyl peroxide (C₆H₅CO)₂O₂, and organic peroxide such as hypochlorous acid (HClO), perchloric acid, nitric acid, ozone water, peracetic acid or nitrobenzene.

Furthermore, the raw material solution may contain dopants. Examples of dopants include, but not particularly limited to, n- type dopants such as tin, germanium, silicon, titanium, zirconium, vanadium or niobium, or p-type dopants such as copper, silver, tin, iridium or rhodium. The concentration of dopants may be, for example, about 1.0×10⁻⁹ to 1.0 mol/L, and may be as low as about 1.0×10⁻⁷ mol/L or less, or as high as about 0.01 mol/L or more.

### (Step for Conveying a Mist)

Then, the generated mist is conveyed to the film-forming part by means of the carrier gas. The type of carrier gas is not particularly limited, and the carrier gas can be selected appropriately depending on the film-forming object. Examples of carrier gases include an inert gas such as oxygen, ozone, nitrogen or argon, or a reducing gas such as hydrogen gas or forming gas. One, two or more types of carrier gases may be used. For example, a dilution gas diluted (e.g., diluted 10 times) the same gas as a first carrier gas with the other gas, may be further used as a second carrier gas, or air can be used.

The flow rate Q [L/min] of the carrier gas according to the present invention represents the total flow rate of the carrier gas. For example, if the carrier gas for dilution is used in addition to the carrier gas, Q is the total flow rate of the carrier gas and the carrier gas for dilution. Note that Q is the measured value at 20°C. If the gas is measured at the other temperatures or at different types of flow rates (mass flow rate, etc.), it can be converted to a volumetric flow rate at 20°C using equation of state of gas.

The flow rate is not particularly limited and may be any flow rates of the carrier gas (the total flow rates if multiple types of gases are used) that meet the conditions described below. For example, when performing the film-formation on the substrate with a diameter of 4 inches (100 mm), it is preferable to be the flow rate of 1 to 80 L/min, and 4 to 40 L/min is more preferable.

### (Step for Performing a Film-Formation)

Then, in the film-forming part, the mist is supplied from the nozzle onto the substrate and heat-treated on the substrate to perform a film-formation. Herein, with the area of the opening surface 152 of the nozzle being S [cm²], the flow rate of the carrier gas being Q [L/min], and the longest distance among distances between points in the opening surface 152 and the surface between the substrate 110 being H [cm], SH/Q may be 0.015 or more, preferably 0.1 or more to 20 or less. If SH/Q is less than 0.015, the film has many pits and the surface of the film is not smooth. In this case, the speed of the carrier gas in the direction orthogonal to the substrate at the opening surface 152 of the nozzle may be between 0.01 m/s or more and less than 8.0 m/s, preferably between 0.1 m/s or more and less than 2.5 m/s.

In this case, the area S of the opening surface 152 of the nozzle may be between 0.1 cm² or more and less than 400 cm². The minimum distance H between the opening surface 152 of the nozzle and the substrate 110 is preferably between 0.1 cm or more and 6.0 cm or less, more preferably between 0.2 cm or more and 3.0 cm or less.

With the area of the opening surface 152 of the nozzle being S [cm²] and the area of the substrate being A [cm²], S/A≤0.3 is preferable, more preferably 0.004≤S/A≤0.15. S/A≤0.3 allows the film to have fewer pits and better surface smoothness. In this case, the area A of the substrate is preferably 10 cm² or more. If the substrate is circular, the diameter is preferably 2 inches (50 mm) or more, as the film with good surface smoothness can be formed on the larger area. The upper limit of A is not particularly limited. The larger area of the substrate, the larger area of the film can be achieved in a single film-formation, and thus it is suitable for mass production.

It is preferable to use a nozzle with a rectangular opening surface. In this case, with the length of the long axis of the opening surface 152 of the nozzle being L [cm] and the maximum length of the substrate in the direction of long axis of the nozzle being R [cm], L/R≥1 is preferable. With L/R≥1, a film having good smoothness can be easily formed on a large area of the substrate. Herein, the long axis refers to the long side of a rectangle. Although the upper limit of L/R is not particularly limited, it is preferably 3 or less, as the larger L/R is, the more mist is not supplied to the substrate.

Heat-treatment is sufficient if the mist reacts by heating, and the reaction conditions, etc. are also not particularly limited. The heat-treatment can be set appropriately according to the raw material or the film-forming object. For example, the heating temperature can be in the range of 120 to 600°C, preferably in the range of 200°C to 600°C, and more preferably in the range of 300°C to 550°C. With the heating temperature being T [°C], the area of the opening surface 152 of the nozzle being S [cm²], and the flow rate of the carrier gas being Q [L/min], ST/Q is preferably 40 or more, more preferably between 100 or more and 2000 or less. ST/Q≥40 allows the film to have further fewer pits and even better surface smoothness.

The heat-treatment may be performed under any atmosphere such as vacuum, non-oxygen atmosphere, reducing gas atmosphere, air atmosphere, and oxygen atmosphere, and can be set as appropriate according to the film-forming object. In addition, the reaction pressure may be under any conditions such as atmospheric, pressurized, or depressurized conditions. However, the film-formation under atmospheric pressure is preferred to allow to simplify the apparatus configuration.

The substrate 110 is not particularly limited and may be any substrate 110 that is capable of performing the film-forming and supporting the film. A material of the substrate 110 is also not particularly limited, and any known substrates can be used, which may be an organic compound or an inorganic compound. Examples of the materials of the substrate 110 include, but are not limited to, polysulfone, polyether sulfone, polyphenylene sulfide, polyetheretherketone, polyimide, polyetherimide, fluororesin, metals such as iron, aluminum, stainless steel, and gold, silicon, sapphire, quartz, glass, gallium oxide, lithium niobate, lithium tantalate, etc. Although the thickness of the substrate is not particularly limited, it is preferably 10 to 2000 µm, and more preferably 50 to 800 µm.

The film-formation may be performed directly on the substrate or may be stacked on an intermediate layer formed on the substrate. The intermediate layer is not particularly limited. For example, the intermediate layer can include any of oxides containing aluminum, titanium, vanadium, chromium, iron, gallium, rhodium, indium, or iridium as main component. More specifically, the metal oxides are Al₂O₃, Ti₂O₃, V₂O₃, Cr₂O₃, Fe₂O₃, Ga₂O₃, Rh₂O₃, In₂O₃, Ir₂O₃, and can be the metal oxide in a binary system represented by (AₓB₁₋ₓ)₂O₃ (0<x<1) when two elements selected from the above metal elements are A and B or the metal oxide in a ternary system represented by (AₓB_{y}C_{1-x-y})₂O₃ (0<x<1, 0<y<1, 0<x+y<1) when three elements selected from the above metal elements are A, B and C.

In the present invention, an anneal treatment may be performed after film-forming. Examples of temperatures for the anneal treatment is, but not particularly limited to, preferably 600°C or less, and more preferably 550°C or less. This is because the crystallinity of the film is not impaired. Although the processing time of the anneal treatment is not particularly limited, it is preferably 10 seconds to 10 hours, and more preferably 10 seconds to 1 hour.

### (Delamination)

The substrate 110 may be delaminated from the oxide semiconductor film. The delaminating method is not particularly limited, and may be any known methods. Examples of methods include a delaminating method by mechanical impact, applying heat and using thermal stress, applying vibration such as ultrasonic waves, etching, laser lift-off, etc. The delamination enables to obtain the oxide semiconductor film as a freestanding film.

### (Electrode)

General method i.e., any of methods such as vapor deposition, sputtering, CVD, plating, as well as a printing method for adhering together with such as a resin can be used to form an electrode required to configure a semiconductor apparatus. Examples of electrode materials include metals such as Al, Ag, Ti, Pd, Au, Cu, Cr, Fe, W, Ta, Nb, Mn, Mo, Hf, Co, Zr, Sn, Pt, V, Ni, Ir, Zn, In, and Nd, as well as conductive metal oxide films such as tin oxide, zinc oxide, indium oxide, indium tin oxide (ITO), zinc indium oxide (IZO), or organic conductive compounds such as polyaniline, polythiophene, or polypyrrole. Any of the above electrode materials may be used. Alloys or mixtures of two or more of these materials may be used. The thickness of the electrode is preferably 1 to 1000 nm, more preferably 10 to 500 nm.

### Film-Forming System

Then, a film-forming system according to the present invention will be described. The present invention is a film-forming system for heat-treating a raw material solution atomized into a mist and performing a film-formation, and the system comprises: a mechanism for atomizing the raw material solution or making the raw material solution into droplets to generate a mist; a mechanism for conveying the mist to a film-forming part by a carrier gas; and a mechanism for supplying the mist from a nozzle to a substrate, heat-treating the mist on the substrate, and performing the film-formation in the film-forming part, wherein with the area of an opening surface of the nozzle being S [cm²], the longest distance among distances between points in the opening surface and the surface of the substrate being H [cm], and the flow rate of the carrier gas supplied from the nozzle being Q [L/min], SH/Q≥0.015 results.

### (Mechanism for Generating a Mist)

First, the raw material solution 104a is atomized or the raw material solution 104a is made into droplets to generate a mist. This mechanism can be performed using the atomizing part 120 as described above. Herein, the raw material solution (aqueous solution) 104a is not particularly limited and may be any raw material solutions (aqueous solutions) 104a containing a material, which may be an inorganic or organic material that can be atomized into a mist. A material solution containing metal or metal compounds is suitable for the raw material solution. The raw material solution containing one or more metal selected from gallium, iron, indium, aluminum, vanadium, titanium, chromium, rhodium, nickel, and cobalt can be used. Among these, the raw material solution containing gallium are particularly preferred, and thus gallium-containing film with suppressed pits and good smoothness can be formed.

The raw material solution is not particularly limited and may be any raw material solutions that can atomize the above metal (compound) into a mist. The metal can be dissolved or dispersed in an organic solvent or water in the form of a complex or salt to suitably use as the raw material solution. Examples of complex forms include acetylacetonate complex, carbonyl complex, amine complex, hydride complex, etc. Examples of salt forms include metal chloride salt, metal bromide salt, and metal iodide salt. The above metal can be also dissolved in hydrobromic acid, hydrochloric acid, hydroiodic acid, etc. to use as an aqueous salt solution. A solute concentration is preferably 0.01 to 1 mol/L. Among these, the raw material solution containing halogen is particularly preferred as it suppresses the pits more and enables the film-formation having better smoothness.

In addition, the raw material solution may be mixed with additives such as hydrohalic acid or oxidant. Examples of hydrohalic acid include hydrobromic acid, hydrochloric acid, and hydroiodic acid. Among these, hydrobromic acid or hydroiodic acid is preferred. Examples of oxidants include peroxide such as hydrogen peroxide (H₂O₂), sodium peroxide (Na₂O₂), barium peroxide (BaO₂), benzoyl peroxide (C₆H₅CO)₂O₂, and organic peroxide such as hypochlorous acid (HClO), perchloric acid, nitric acid, ozone water, peracetic acid or nitrobenzene.

Furthermore, the raw material solution may contain dopants. Examples of dopants include, but not particularly limited to, n- type dopants such as tin, germanium, silicon, titanium, zirconium, vanadium or niobium, or p-type dopants such as copper, silver, tin, iridium or rhodium. The concentration of dopants may be, for example, about 1.0×10⁻⁹ to 1.0 mol/L, and may be as low as about 1.0×10⁻⁷ mol/L or less, or as high as about 0.01 mol/L or more.

### (Mechanism for Conveying a Mist)

Then, the generated mist is conveyed to the film-forming part by means of the carrier gas. This mechanism can be performed using the conveying part 109 as described above. Herein, the type of the carrier gas is not particularly limited, and the carrier gas can be selected appropriately depending on the film-forming object. Examples of carrier gases include an inert gas such as oxygen, ozone, nitrogen or argon, or a reducing gas such as hydrogen gas or forming gas. One, two or more types of carrier gases may be used. For example, a dilution gas diluted (e.g., diluted 10 times) the same gas as a first carrier gas with the other gas, may be further used as a second carrier gas, or air can be used.

The flow rate Q [L/min] of the carrier gas according to the present invention represents the total flow rate of the carrier gas. For example, if carrier gas for dilution is used in addition to the carrier gas, Q is the total flow rate of the carrier gas and the carrier gas for dilution. Note that Q is the measured value at 20°C. If the gas is measured at the other temperatures or at different types of flow rates (mass flow rate, etc.), it can be converted to a volumetric flow rate at 20°C using equation of state of gas.

The flow rate is not particularly limited and may be any flow rates of the carrier gas (the total flow rates if multiple types of gases are used) that meet the conditions described below. For example, when performing the film-formation on the substrate with a diameter of 4 inches (100 mm), it is preferable to use the flow rate of 1 to 80 L/min, and 4 to 40 L/min is more preferable.

### (Mechanism for Performing a Film-Formation)

Then, in the film-forming part 140, the mist is supplied from the nozzle onto the substrate and heat treated on said substrate to perform a film-formation. Herein, with the area of the opening surface 152 of the nozzle being S [cm²], the flow rate of the carrier gas being Q [L/min], and the longest distance among distances between points in the opening surface 152 and the surface between the substrate 110 being H [cm], SH/Q may be 0.015 or more, preferably 0.1 or more to 20 or less. If SH/Q is less than 0.015, the film has many pits and the surface of the film is not smooth. In this case, the speed of the carrier gas in the direction orthogonal to the substrate at the opening surface 152 may be between 0.01 m/s or more and less than 8.0 m/s, preferably between 0.1 m/s or more and less than 2.5 m/s.

In this case, the area S of the opening surface 152 of the nozzle may be between 0.1 cm² or more and less than 400 cm². The minimum distance H between the opening surface 152 of the nozzle and the substrate 110 is preferably between 0.1 cm or more and 6.0 cm or less, more preferably between 0.2 cm or more and 3.0 cm or less.

With the area of the opening surface 152 of the nozzle being S [cm²] and the area of the substrate being A [cm²], S/A≤0.3 is preferable, more preferably 0.004≤S/A≤0.15. S/A≤0.3 allows the film to have fewer pits and better surface smoothness. In this case, the area A of the substrate is preferably 10 cm² or more. If the substrate is circular, the diameter is preferably 2 inches (50 mm) or more, as the film having good surface smoothness can be formed on the larger area. The upper limit of A is not particularly limited. The larger the area of the substrate, the larger area of the film can be achieved in a single film-formation, and thus it is suitable for mass production.

It is preferable to use a nozzle with a rectangular opening surface. In this case, with the length of the long axis of the opening surface 152 of the nozzle being L [cm] and the maximum length of the substrate in the direction of long axis of the nozzle being R [cm], L/R≥1 is preferable. With L/R≥1, a film having good smoothness can be easily formed on a large area of the substrate. Herein, the long axis refers to the long side of a rectangle. Although the upper limit of L/R is not particularly limited, it may be preferably 3 or less, as the larger L/R is, the more mist is not supplied to the substrate.

Heat-treatment is sufficient if the mist reacts by heating, and the reaction conditions, etc. are not particularly limited. The heating temperature can be set appropriately according to the raw materials or the film-forming object. For example, the heating temperature can be in the range of 120 to 600°C, preferably in the range of 200°C to 600°C, and more preferably in the range of 300°C to 550°C. With the heating temperature being T [°C], the area of the opening surface 152 of the nozzle being S [cm²], and the flow rate of the carrier gas being Q [L/min], ST/Q is preferably 40 or more, more preferably between 100 or more and 2000 or less. ST/Q≥40 allows the film to have further fewer pits and even better surface smoothness.

The heat-treatment may be performed under any atmosphere such as vacuum, non-oxygen atmosphere, reducing gas atmosphere, air atmosphere, and oxygen atmosphere, and can be set as appropriate according to the film-forming object. In addition, the reaction pressure may be under any conditions such as atmospheric, pressurized, or depressurized conditions. However, the film-formation under atmospheric pressure is preferred to allow to simplify the apparatus configuration.

The substrate 110 is not particularly limited and may be any substrate 110 that is capable of performing the film-formation and supporting the film. A material of the substrate 110 is also not particularly limited, and any known substrates can be used, which may be an organic compound or an inorganic compound. Examples of the materials of the substrate 110 include, but are not limited to, polysulfone, polyether sulfone, polyphenylene sulfide, polyetheretherketone, polyimide, polyetherimide, fluororesin, metals such as iron, aluminum, stainless steel, and gold, silicon, sapphire, quartz, glass, gallium oxide, lithium niobate, lithium tantalate, etc. Although the thickness of the substrate is not particularly limited, it is preferably 10 to 2000 µm, and more preferably 50 to 800 µm.

The film-formation may be performed directly on the substrate or may be stacked on an intermediate layer formed on the substrate. The intermediate layer is not particularly limited. For example, the intermediate layer can include any of oxides containing aluminum, titanium, vanadium, chromium, iron, gallium, rhodium, indium, or iridium as main component. More specifically, the metal oxides are Al₂O₃, Ti₂O₃, V₂O₃, Cr₂O₃, Fe₂O₃, Ga₂O₃, Rh₂O₃, In₂O₃, Ir₂O₃, and can be the metal oxide in a binary system represented by (AₓB₁₋ₓ)₂O₃ (0<x<1) when two elements selected from the above metal elements are A and B or the metal oxide in a ternary system represented by (AₓB_{y}C_{1-x-y})₂O₃ (0<x<1, 0<y1, 0<x+y<1) when three elements selected from the above metal elements are A, B and C.

In the present invention, an anneal treatment may be performed after film-forming. Examples of temperatures for the anneal treatment is, but not particularly limited to, preferably 600°C or less, and more preferably 550°C or less. This is because the crystallinity of the film is not impaired. Although the processing time of the anneal treatment is not particularly limited, it is preferably 10 seconds to 10 hours, and more preferably 10 seconds to 1 hour.

### (Delamination)

The substrate 110 may be delaminated from the oxide semiconductor film. The delaminating method is not particularly limited, and may be any known methods. Examples of methods include a delaminating method by mechanical impact, applying heat and using thermal stress, applying vibration such as ultrasonic waves, etching, laser lift-off, etc. The delamination enables to obtain the oxide semiconductor film as a freestanding film.

### (Electrode)

General method i.e., any of methods such as vapor deposition, sputtering, CVD, plating, as well as a printing method for adhering together with a resin can be used to form the electrodes required to configure a semiconductor apparatus. Examples of electrode materials include metals such as Al, Ag, Ti, Pd, Au, Cu, Cr, Fe, W, Ta, Nb, Mn, Mo, Hf, Co, Zr, Sn, Pt, V, Ni, Ir, Zn, In, and Nd, as well as conductive metal oxide films such as tin oxide, zinc oxide, indium oxide, indium tin oxide (ITO), zinc indium oxide (IZO), or organic conductive compounds such as polyaniline, polythiophene, or polypyrrole. Any of the above electrode materials may be used. Alloys or mixtures of two or more of these materials may be also used. The thickness of the electrode is preferably 1 to 1000 nm, more preferably 10 to 500 nm.

### EXAMPLES

Hereinafter, the present invention will be specifically described with reference to Examples and Comparative Examples. However, the present invention is not limited thereto.

### (Example 1)

In this example, the film-forming apparatus shown in FIG. 1 was used.

Tin chloride was mixed with 0.05 mol/L gallium iodide aqueous solution to prepare an aqueous solution so that an atomic ratio of tin to gallium is 1 to 0.08, which was used as the raw material solution 104a. The raw material solution 104a obtained as described above was contained into the mist generating source 104. In this time, the temperature of the solution was 25°C.

Then, c-face sapphire substrate with 4 inches (100 mm diameter) was placed on the hot plate 108 in the film-forming chamber 107 as the substrate 110, and the hot plate 108 was operated to raise the temperature to 500°C.

Subsequently, flow control valves 103a and 103b were opened to supply nitrogen gas as a carrier gas from the carrier gas sources 102a and 102b into the film-forming chamber 107 to fully replace the atmosphere of the film-forming chamber 107 by means of the carrier gas, as well as the flow rates of the main carrier gas and the carrier gas for dilution were adjusted to 12 L/min, respectively.

Then, the ultrasonic wave vibration 106 was vibrated at 2.4 MHz, and the vibration was propagated through the water 105a to the raw material solution 104a, and thereby the raw material solution 104a was atomized to generate a mist.

This mist was supplied to the substrate 110 through the supply pipe 109a and the nozzle 150 by means of the carrier gas. As the nozzle 150, the nozzle with a rectangular-shaped opening surface 152 was used, and the nozzle was adjusted so that with the area of the opening surface 152 of the nozzle being S [cm²], the flow rate of the carrier gas being Q [L/min], and the longest distance among distances between points in the opening surface 152 of the nozzle and the surface of the substrate 110 being H [cm], SH/Q=0.5 resulted. In this case, S=6.0, H=2.0, and Q=24.

Then, the mist was heat-treated in the film-forming chamber 107 at 500°C under atmospheric pressure to form a thin film containing the gallium oxide (*α*-Ga₂O₃) having the corundum structure on the substrate 110. The film-forming time was set at 30 minutes.

With the heat-treatment temperature being set to T [°C], ST/Q=40 resulted, with the area of the substrate being set to A [cm²], S/A=0.024 resulted, and with the length of the long axis of the opening surface 152 of the nozzle being set to L [cm] and the maximum length of the nozzle long axis direction of the substrate being R [cm], L/R=1.2 resulted. In this case, T=500, A=78.5, L=12, and R=10.

The substrate was moved back and forth by the moving mechanism as shown in FIG. 10, so that the substrate and the hot plate passed under the nozzle once per minute at a speed of 15 cm/min.

Subsequently, an n- semiconductor film was stacked as a second layer on the n+ semiconductor film obtained as described above under the same conditions using the same raw material solution as described above except that it did not contain tin chloride.

### (Example 2)

The film-formation was performed in the same manner as in Example 1, except that the area S of the opening surface of the nozzle was changed to 10.8 cm², the total flow rate of the carrier gas was changed to 40 L/min in total, and the film-forming temperature T was changed to 550°C. At this time, SH/Q=0.54, ST/Q=149, and S/A=0.15 resulted.

### (Example 3)

The film-formation was performed in the same manner as in Example 2, except that the total flow rate of the carrier gas was changed to 20 L/min in total and the film-forming temperature T was changed to 500°C. At this time, SH/Q=1.08, ST/Q=270, and S/A=0.15 resulted.

### (Example 4)

The film-formation was performed in the same manner as in Example 2, except that the film-forming temperature T was changed to 500°C. At this time, SH/Q=0.54, ST/Q=135, and S/A=0.15 resulted.

### (Example 5)

The film-formation was performed in the same manner as in Example 1, except that the concentration of the raw material solution was changed to 0.3 mol/L, the area S of the opening surface of the nozzle was changed to 1.2 cm², the longest distance H among distances between points in the opening surface 152 of the nozzle and the surface of the substrate 110 was changed to 2.5 cm, and the total flow rate of the carrier gas was changed to 14 L/min in total. At this time, SH/Q=0.21, ST/Q=42.9, and S/A=0.015 resulted.

### (Example 6)

The film-formation was performed in the same manner as in Example 5, except that a 0.3 mol/L gallium bromide aqueous solution was used as the raw material solution, and the longest distance H among distances between points in the opening surface 152 of the nozzle and the surface of the substrate 110 was changed to 1.6 cm, wherein SH/Q=0.14, ST/Q=42.9, and S/A=0.015 resulted.

### (Example 7)

The film-formation was performed in the same manner as in Example 1, except that a sapphire substrate with 6-inch (150 mm diameter) was used as the substrate 110, the area S of the opening surface of the nozzle was changed to 8.5 cm², the longest distance H among distances between points in the opening surface 152 of the nozzle and the surface of the substrate 110 was changed to 0.2 cm, and the total flow rate of the carrier gas was changed to 36 L/min in total. At this time, SH/Q=0.047, ST/Q=118, S/A=0.048, and L/R=1.1 resulted.

### (Example 8)

The film-formation was performed in the same manner as in Example 1, except that an aqueous solution with a 0.05 mol/L gallium acetylacetonate complex dissolved in water containing 1.5% hydrochloric acid by volume was used as the raw material solution, the area S of the opening surface of the nozzle was changed to 1.2 cm², the longest distance H among distances between points in the opening surface 152 of the nozzle and the surface of the substrate 110 was changed to 0.2 cm, the total flow rate of the carrier gas was changed to 10 L/min in total, and the film-forming temperature T was changed to 450°C. At this time, SH/Q=0.024, ST/Q=54, and S/A=0.015 resulted.

### (Example 9)

The film-formation was performed in the same manner as in Example 6, except that the longest distance H among distances between points in the opening surface 152 of the nozzle and the surface of the substrate 110 was changed 1.2 cm. At this time, SH/Q=0.1, ST/Q=42.9, and S/A=0.015 resulted.

### (Example 10)

The film-formation was performed in the same manner as in Example 1, except that the area S of the opening surface of the nozzle was changed to 24 cm², the longest distance H among distances between points in the opening surface 152 of the nozzle and the surface of the substrate 110 was changed to 0.2 cm, the total flow rate of the carrier gas was changed to 80 L/min in total, and the film-forming temperature T was changed to 550°C. At this time, SH/Q=0.06, ST/Q=165, and S/A=0.30 resulted.

### (Example 11)

The film-formation was performed in the same manner as in Example 1, except that the area S of the opening surface of the nozzle was changed to 5.0 cm², the longest distance H among distances between points in the opening surface 152 of the nozzle and the surface of the substrate 110 was changed to 0.2 cm, the total flow rate of the carrier gas was changed to 60 L/min in total. At this time, SH/Q=0.017, ST/Q=41.7, S/A=0.064, and L/R=1.0 resulted.

### (Example 12)

The film-formation was performed in the same manner as in Example 1, except that the shape of the opening surface of the nozzle was circular with 4 inches (100 mm) in diameter, the longest distance H among distances between points in the opening surface 152 of the nozzle and the surface of the substrate 110 was changed to 0.2 cm, the substrate was not moved, the flow rate of the carrier gas was changed to 80 L/min in total, and the heating temperature was 550°C. At this time, SH/Q=0.20, ST/Q=540, S/A=1, and L/R=1 resulted.

### (Example 13)

The film-formation was performed in the same manner as in Example 6, except that a 0.05 mol/L gallium bromide aqueous solution was used as the raw material solution and deuterium bromide was added 10% by volume, the longest distance H among distances between points in the opening surface 152 of the nozzle and the surface of the substrate 110 was changed to 0.2 cm, and the film-forming temperature T was changed to 470°C. At this time, SH/Q=0.017, ST/Q=40, and S/A=0.015 resulted.

### (Example 14)

The film-formation was performed in the same manner as in Example 6, except that a gallium bromide aqueous solution with 0.05 mol/L was used as the raw material solution, the longest distance H among distances between points in the opening surface 152 of the nozzle and the surface of the substrate 110 was changed to 0.2 cm, the total flow rate of the carrier gas was changed to 16 L/min in total, and the film-forming temperature T was changed to 450°C. At this time, SH/Q=0.015, ST/Q=33.8, and S/A=0.015 resulted.

### (Comparative Example 1)

The film-formation was performed in the same manner as in Example 14, except that the total flow rate of the carrier gas was changed to 20 L/min in total. At this time, SH/Q=0.012, ST/Q=27, and S/A=0.015 resulted.

### (Comparative Example 2)

The film-formation was performed in the same manner as in Example 14, except that the total flow rate of the carrier gas was changed to 24 L/min in total. At this time, SH/Q=0.01, ST/Q=22.5, and S/A=0.015 resulted.

### (Comparative Example 3)

The film-formation was performed in the same manner as in Example 14, except that the total flow rate of the carrier gas was changed to 48 L/min in total. At this time, SH/Q=0.005, ST/Q=11.3, and S/A=0.015 resulted.

### (Comparative Example 4)

The film-formation was performed in the same manner as in Example 14, except that the total flow rate of the carrier gas was changed to 60 L/min in total. At this time, SH/Q=0.004, ST/Q=9, and S/A=0.015 resulted.

### (Test Example 1)

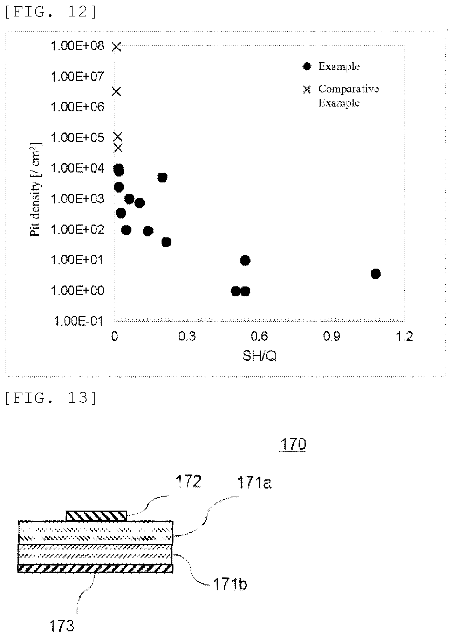

The surface of the film after film-forming was observed using an optical microscope, and the number of pits within 0.01 to 1 cm² were counted. The pit density calculated by dividing the counted number of the pits part by the observed area was shown in Table 1. The plotted results of the pit density against SH/Q are shown in FIG. 12.

### (Test Example 2)

Using the semiconductor film obtained as described above, a semiconductor apparatus 170 as shown in FIG. 13 was created.

### <Formation of Schottky Electrode>

On a n- type semiconductor layer 171a, a Pt layer, a Ti layer, and an Au layer were each stacked by electron beam evaporation to form a Schottky electrode 172.

### <Formation of Ohmic Electrode>

On a n+ type semiconductor layer 171b, a Ti layer and an Au layer were each stacked by electron beam evaporation to form an ohmic electrode 173.

### <Evaluation>

The resulting semiconductor apparatus was evaluated for current-voltage characteristics. The voltage at which a dielectric breakdown occurs was examined by measuring the current-voltage characteristics in the reverse direction. The semiconductor apparatus with a withstand voltage of 300 V or higher was determined as accepted products, and the yield was calculated as the number of accepted products/the total number of created semiconductor apparatus=yield [%]. The results are shown in Table 1.

FIG. 14 shows the yield plotted against the pit density calculated in Test Example 1.

**[Table 1]**

| | Raw material | Opening shape | Conveyance | SH/Q | ST/Q | S/A | L/R | Pit density [/cm²] | Yield [%] |
|---|---|---|---|---|---|---|---|---|---|
| Ex. 1 | GaI₃ | rectangle | reciprocating | 0.5 | 125 | 0.076 | 1.2 | <1 | 98 |
| Ex. 2 | GaI₃ | rectangle | reciprocating | 0.54 | 14 9 | 0.150 | 1.2 | <1 | 98 |
| Ex. 3 | GaI₃ | rectangle | reciprocating | 1.08 | 270 | 0.150 | 1. 2 | 4 | 96 |
| Ex. 4 | GaI₃ | rectangle | reciprocating | 0.54 | 135 | 0.150 | 1. 2 | 10 | 94 |
| Ex. 5 | GaI₃ | rectangle | reciprocating | 0.21 | 42.9 | 0.015 | 1.2 | 41 | 90 |
| Ex. 6 | GaBr₃ | rectangle | reciprocating | 0.14 | 42.9 | 0.015 | 1. 2 | 91 | 86 |
| Ex. 7 | GaI₃ | rectangle | reciprocating | 0.047 | 118 | 0.048 | 1.1 | 1.00E+02 | 85 |
| Ex. 8 | Ga(acac)₃ | rectangle | reciprocating | 0.024 | 54 | 0.015 | 1.2 | 3.49E+02 | 71 |
| Ex. 9 | GaBr₃ | rectangle | reciprocating | 0.1 | 42.9 | 0.015 | 1.2 | 7.41E+02 | 61 |
| Ex. 10 | GaI₃ | rectangle | reciprocating | 0.06 | 165 | 0.300 | 1.2 | 1.00E+03 | 56 |
| Ex. 11 | GaI₃ | rectangle | reciprocating | 0.017 | 41.7 | 0.064 | 1 | 2.45E+03 | 35 |
| Ex. 12 | GaI₃ | circle | none | 0.2 | 540 | 1.000 | 1 | 5.04E+03 | 21 |
| Ex. 13 | GaBr₃ | rectangle | reciprocating | 0.017 | 40 | 0.015 | 1.2 | 8.20E+03 | 13 |
| Ex. 14 | GaI₃ | rectangle | reciprocating | 0.015 | 33.8 | 0.015 | 1.2 | 1.00E+04 | 10 |
| Comp. Ex. 1 | GaI₃ | rectangle | reciprocating | 0.012 | 27 | 0.015 | 1.2 | 4.92E+04 | 3 |
| Comp. Ex. 2 | GaI₃ | rectangle | reciprocating | 0.01 | 22.5 | 0.015 | 1.2 | 1.14E+05 | 1 |
| Comp. Ex. 3 | GaI₃ | rectangle | reciprocating | 0.005 | 11.3 | 0.015 | 1.2 | 3.43E+06 | 0 |
| Comp. Ex. 4 | GaI₃ | rectangle | reciprocating | 0.004 | 9 | 0.015 | 1. 2 | 9.87E+07 | 0 |

From the comparison between Examples 1 to 14 and Comparative Examples 1 to 4, it was found that the film-formation is performed using the film-forming method that with the area of an opening surface of the nozzle being S [cm²], the longest distance among distances between points in the opening surface and the surface of the substrate being H [cm], and the flow rate of the gas supplied from the nozzle being Q [L/min], SH/Q≥0.015 results, and thus enabling a film to have suppressed pits and excellent smoothness, and a semiconductor apparatus with high breakdown voltage to fabricate with excellent yields.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.

## Claims

1. An oxide semiconductor film including gallium as main component, comprising:
a corundum structure,
wherein pits on the surface of the oxide semiconductor film are 10000 pits/cm² or less.

2. The oxide semiconductor film according to claim 1, wherein the pits on the surface of the oxide semiconductor film are 100 pits/cm² or less.

3. The oxide semiconductor film according to claim 1 or 2, wherein the oxide semiconductor film has an area of 10 cm² or more.

4. The oxide semiconductor film according to any one of claims 1 to 3, wherein the pits on the surface of the oxide semiconductor film have an opening diameter of 10 nm to 10 µm and the pits have a depth of 10 nm to 10 pm.

5. A semiconductor apparatus, comprising the oxide semiconductor film according to any one of claims 1 to 4.

6. A film-forming method for heat-treating a raw material solution atomized into a mist and performing a film-formation, the method comprises the following steps:
atomizing the raw material solution or making the raw material solution into droplets to generate a mist;
conveying the mist to a film-forming part by a carrier gas; and
supplying the mist from a nozzle to a substrate, heat-treating the mist on the substrate, and performing the film-formation in the film-forming part,
wherein with the area of an opening surface of the nozzle being S [cm²], the longest distance among distances between points in the opening surface and the surface of the substrate being H [cm], and the flow rate of the carrier gas supplied from the nozzle being Q [L/min], SH/Q≥0.015 results.

7. The film-forming method according to claim 6, wherein the raw material solution contains gallium.

8. The film-forming method according to claim 6 or 7, wherein the raw material solution contains halogen.

9. The film-forming method according to any one of claims 6 to 8, wherein with the temperature of the heat-treatment being T[°C], ST/Q≥40 results.

10. The film-forming method according to any one of claims 6 to 9, wherein the mist is supplied to the substrate from the nozzle provided vertically above the substrate.

11. The film-forming method according to claim 10, wherein the substrate is moved under the nozzle.

12. The film-forming method according to claim 11, wherein with the area of the surface of the substrate to be performed the film-formation being A [cm²], S/A≤0.3 results.

13. The film-forming method according to any one of claims 6 to 12, wherein the opening surface of the nozzle is rectangular.

14. The film-forming method according to claim 13, wherein with the length of the long axis of the opening surface of the nozzle being L [cm] and the maximum length in the long axis direction of the nozzle within the surface of the substrate to be performed the film-formation being R [cm], L/R≥1 results.

15. The film-forming method according to any one of claims 6 to 14, wherein the area of the substrate is 10 cm² or more.
